(19) Europäisches Patentamt
European Patent Office
Office européen des brevets

(11) **EP 1 900 025 B1**

(12) **EUROPEAN PATENT SPECIFICATION**

(45) Date of publication and mention
of the grant of the patent:
**10.02.2010 Bulletin 2010/06**

(21) Application number: **06772454.2**

(22) Date of filing: **07.06.2006**

(51) Int Cl.:
**H01L 23/538** (2006.01)

(86) International application number:
**PCT/US2006/022163**

(87) International publication number:
**WO 2006/135643 (21.12.2006 Gazette 2006/51)**

(54) **Hybrid conductive coating method for electrical bridging connection of RFID die chip to composite antenna**

Hybrides leitfähiges Beschichtungsverfahren zur elektrischen Brückenverbindung von RFID-Einzelchips mit einer Verbundantenne

Procédé de revêtement conducteur hybride pour connexion électrique entre une puce de dispositif d'identification par fréquence radio (RFID) et une antenne composite

(84) Designated Contracting States:
**AT BE BG CH CY CZ DE DK EE ES FI FR GB GR HU IE IS IT LI LT LU LV MC NL PL PT RO SE SI SK TR**

(30) Priority: **09.06.2005 US 688875 P**

(43) Date of publication of application:
**19.03.2008 Bulletin 2008/12**

(73) Proprietors:
• **Burgess, Lester, E.**
**Swarthmore, PA 19081 (US)**
• **Kovac, F. Gary**
**Sewickley, PA 15143 (US)**

(72) Inventors:
• **Burgess, Lester, E.**
**Swarthmore, PA 19081 (US)**
• **Kovac, F. Gary**
**Sewickley, PA 15143 (US)**

(74) Representative: **Thoma, Michael et al**
**Lorenz - Seidler - Gossel**
**Widenmayerstraße 23**
**80538 München (DE)**

(56) References cited:
**EP-A- 1 143 378          FR-A- 2 745 120**
**US-A1- 2002 109 225**

**Description**

BACKGROUND

1. Field of the Invention

The present invention relates to RFID tags and more particularly to a direct non-lead method for electrically joining the termination pads of an integrated circuit (IC) die chip to the carrier substrate/mounted antenna, thus providing a single plane configured device.

2. Background of the Art

Radio frequency identification (RFID) is well known and commonly used, for example, to keep track of movable items such as merchandise, animals, automobiles, etc. to which a RFID transponder, or "tag," is attached. The tag typically includes a computer chip and an antenna, and is read by a reader device which can be some distance away from the tag. The tag can be a passive tag, which has no power source but is activated by radio frequency energy transmitted by the reader, or active tag which has its own power source, such as a battery. The RFID chip typically includes a semiconductor memory in which digital information is stored, and can be electrically erasable programmable read only memory (EEPROM) or a similar electronic memory device. Under a technique referred to as "Backscatter modulation" the RFID tags transmit stored data by reflecting varying amounts of an electromagnetic field provided by an RFID interrogator (a read device) by modifying their antenna matching impedances.

RFID systems can be operated at various radio frequencies. Low frequencies (125 - 148 kHz) typically require the reader and the tag to be in close proximity (within about 0.914 m (3 feet)). Ultrahigh frequency (UHF), typically 850 to 960 MHz, allows up to 15.24 m (50 feet) distance between tag and reader, and microwave frequency (typically 2.45 GHz) allows up to 30,48 m (100 feet) distance and is used for highway toll collection and vehicle identification. High frequency (HF) normally operates in the 13.56 MHz range and is used in access and transit cards; also the pharmaceutical industry.

RFID tag fabrication manufacturing systems deal with the lead based solder problem of electronic circuits.

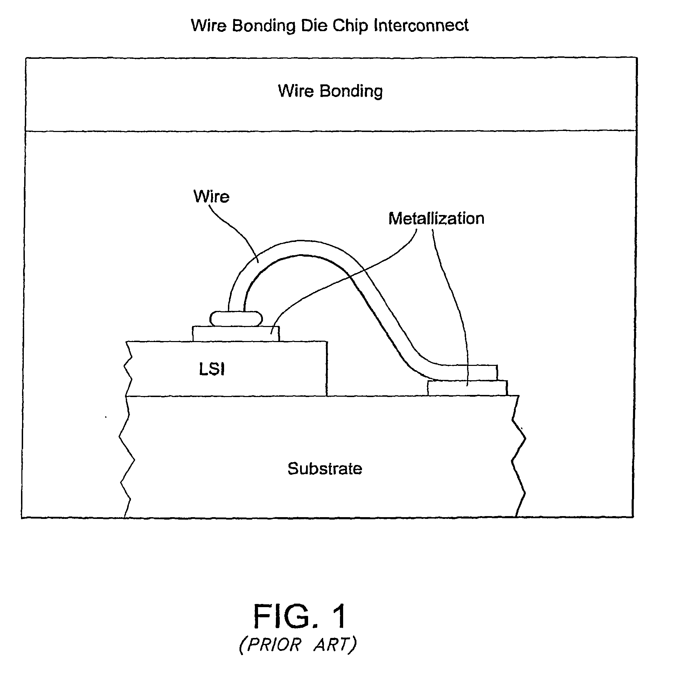

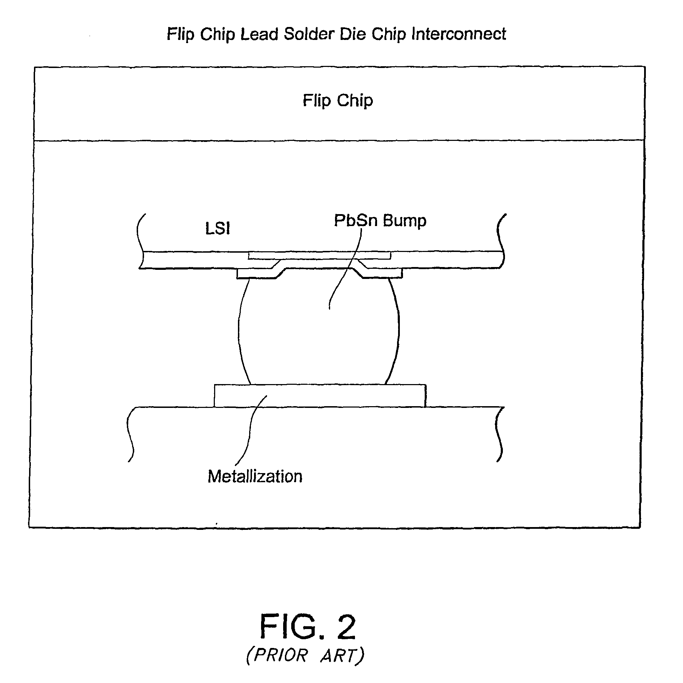

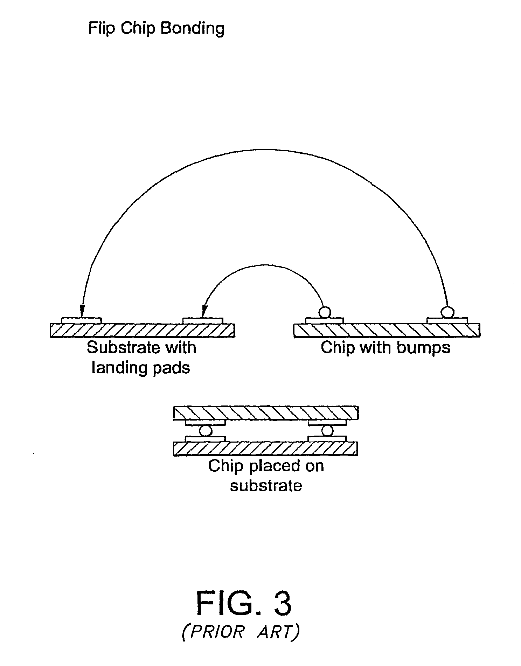

IC Die Bonding or the method of assembling a chip onto a substrate has been developed and optimized for decades and is known as conventional die bonding technology. The early Die Bonding was Wire Bonding for the interconnect between the die pad and the antenna. (See Figure 1) This technology gave way to Flip Chip Bonding. (See Figure 2). Using eutectic solder as the bump materials is well known technology since IBM introduced their C4 Flip chip technology years ago. Lead eutectic solder was applied to the chip by ball placements or solder paste printed to the pads. By using a reflow process the solder is melted and formed to balls, or "bumps". Flip chip is the type of mounting extensively used for semiconductor devices, such as IC chips, which does not require any wire bonds. Instead the final wafer processing step deposits solder beads on the chip pads. After cutting the wafer into individual dice, the "flip chip" is then mounted upside down in/on the package and the solder reflowed. Flip chips then normally will undergo an underfill process which will cover the sides of the die, similar to the encapsulation process. The terminology *flip chip* originates from the upside down (i.e. flipped) mounting of the die (See Figure 3). This leaves the chip pads and their solder beads, or bumps, facing down onto the package, while the back side of the die faces up. This mounting is also known as the Controlled Collapse Chip Connection, or "C4".

There several materials and methods for Flip Chip bonding: Cold compression: Thermo Compression, Lead Eutectic Soldering, Gold Eutectic Soldering, Thermo/Ultrasonic, and Adhesive Technologies, ACP (Anisotropic Conductive Pastes) or ACF (Anisotropic Conductive Films). These methods have one thing in common - direct pressure as a requirement and with direct heat. The instant invention eliminates the need for these requirements

There are Direct and Indirect Flip Chip Assembly methods used in the manufacturing of RFID tags. In direct assembly, the chip's bumps are positioned and placed directly onto the antenna connections by means of flip chip technology. The key advantage is a lower packaging cost, because this requires fewer process steps and consumes less material. However, despite the large antenna pitch, high throughput rates necessitate negligible indexing timing. Thus - with a conventional flip chip bonder approach - the technology is not without its challenges, which will be more manageable the bigger the bonding area of the antenna web. However, the trade-off with a bigger bonding area is longer travel time for chip transport. A well-balanced dimensioning of the bonding area will result in a successful machine concept.

As an alternative, various manufacturers employ indirect RFID chip assembly. Indirect assembly, as a first process step, introduces a flip chip interposer. In a subsequent step, at very high throughput and low cost of ownership, the interposer is mounted on the antenna, which can be done by crimping. Indirect assembly is advantageous especially for manufacturers who have no previous experience with bare-chip processing and do not want to invest in gathering the necessary know-how. The instant invention does not use an interposer. It is much simpler technology.

For example, of the non- lead technologies, the adhesive forms of flip chip mounting that are gaining favor in the world today is adhesive flip chip bonding. There are several forms of this technology, depending on the requirements. A form of flip chip using non-conductive adhesive film to directly bond a stud-bumped IC to a fine line circuit board has been reported. Because the adhesive film does not contain conductive particles, as in the case of conductive adhesives, it can be used for smaller pad pitches. The film also acts as a encapsulant, or underfill material, for thermal-mechanical management.

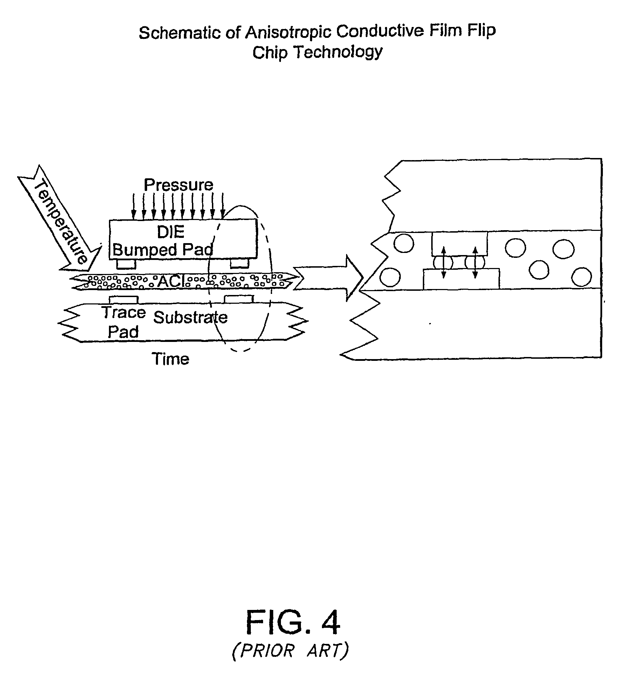

The other form of adhesive flip chip mounting utilizes an anisotropic conductive material, in either a film (ACF) or adhesive (ACA) form, as the electrical and mechanical joining agent. Anisotropic conductive film looks like paper and consists of thermosetting adhesive, conductive particles, and release film. Figure 4 is a schematic representation of anisotropic conductive film flip chip technology. Anisotropic conductive adhesive looks like paste and consists of thermosetting adhesive and conductive particles. Several advantages to adhesive flip chip mounting technologies are noted: In general, the pad pitch of the die is finer than possible with solder flip chip. The cleaning step is not as rigorous as with solder based systems, it eliminates process steps such as coating the interconnect pads with solder and eliminates the use of lead. The bumping process may be simplified by the use of stud bumping, which utilized the same processes and equipment to form a bump as to wire bond to a IC pad.

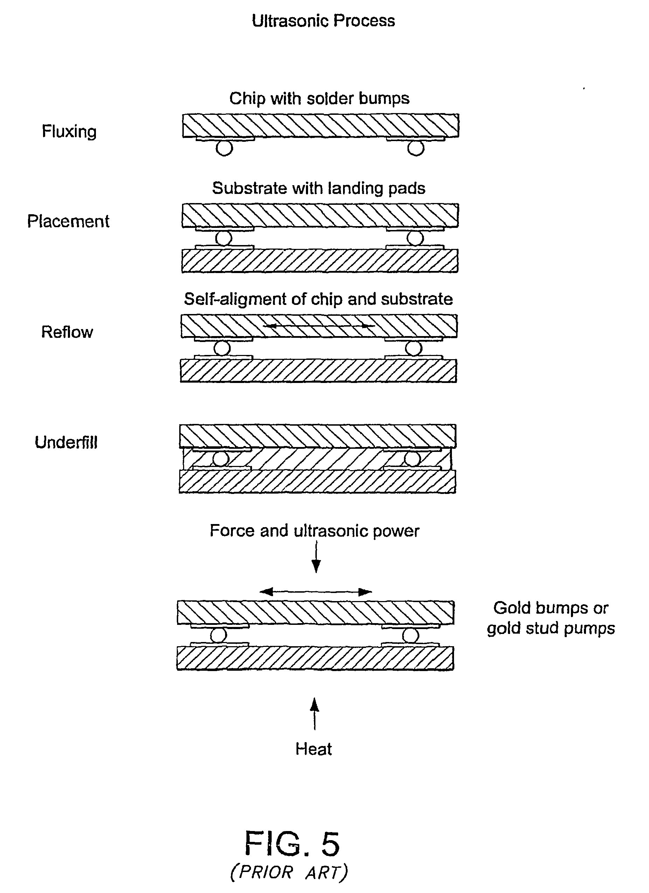

Other examples of Flip Chip bond are where thermo-compression and ultrasonic energy are used to form a gold ball bond on the IC pad; the wire is cut at the top of the ball and leveled, creating a gold bump suitable for ACF bonding to a substrate. See Figure 5 for Ultrasonic Bonding. The instant invention is competitive with all these technologies because their electrical interconnect process not only require a bump design, direct pressure and heat, but as in some flip chip bonding cases, does not require underfill material, for thermal-mechanical, and humidity sealing

Based on this know-how, equipment vendors derived advanced die bonding machines which can do high-speed flip chip assembly. Due to the proposed huge volume demand of RFID tags, a couple of alternative approaches (for example, Fluidic Self Assembly and Vibratory Assembly, referred to as "visionary approaches" in this context, seem to offer a solution for the challenge . The big advantages of conventional and advanced die bonding equipment are both mature technology with the benefit of low investment risk and high-yield operation.

Worldwide movement in the electronics industry to replace lead-tin eutectic solders with lead-free solders currently has reached new elevated threshold. NEMI Lead-free Assembly Project was launched in 1999 to assist North American companies to develop lead-free products by 2001. A development of lead-free solder substitute is now underway. Because of lead toxicity in multiple forms, the electronics industry is embracing environmental issues that involves the take-back of products and an appropriate end-of-life treatment. Legislation in Europe, proposed a ban on lead in most consumer electronics. In Asia, some major Japanese OEMs, such as Hitachi, NEC, Panasonic/ Matshusita, Sony and Toshiba, are developing recycling processes for electronic products, with various commitments to eliminate lead in their products. Lead-free solder activity in the U.S. to ban lead in electronics in the early 1990's has been low. However, the very real prospect of electronics assembly-without lead-based solders-is, in the U.S, on the horizon. There is no one-to-one direct substitute to replace lead, and finding an alternative to lead is not a simple task. The UK's International Tin Research Institute (ITRI) has shown that the most likely substitute will be some combination of Sn (tin), Cu (copper) and/or Ag (silver). Solders with melting temperatures <183°C have found acceptance in consumer and telecommunications, and this temperature (183°C), is required in demanding automotive applications. The main alloy for general-purpose soldering will be SnAgCu, with a melting point of 217°C. However, this high temperature can damage the die chip.

EP 1143378 describes an RFID comprising a non-conductive first substrate, an integrated circuit (flip chip) mounted on the first substrate and having a conductive terminal, and a patterned conductive coating on the first substrate and in contact with the conductive terminal. More particularly, the chip is mounted to a substrate with the chip terminal connected to the antenna coil by a gold wire. Furthermore, document FR 2,745,120 discloses two polymer layers between which a layer of gold is sandwiched. The polymer layers are made of a polymer having a molecular structure which is itself conductive.

SUMMARY

The present invention provides a radio frequency identification device as defined in claim 1 and a method for making such a radio frequency identification device as defined in claim 8. Preferred embodiments of the invention are laid down in the dependent claims.

As a significant part of the instant RFID invention, provided herein is a moisture resistant hybrid composite conductive coating having high adhesion to most substrates which can be applied in a simplified process for large or small antenna design, and a bridging junction over and between said antenna and the die chip contact terminals. The conductivity of the coating can be controlled by the amount and type of conductive adhesive filler blended in the matrix and special formulated process application solvent system. The bridging coating has the same essential conductive plastic filler composition, but preferably contains a higher conductive filler level, and higher viscosity.

The die chip/non-conductive substrate configuration can be fabricated from a printed circuit board with the antenna photo etched cut (or printed) on the board to the desired configuration, thereafter the conductive coating which bridges the gap between the IC die chip element and the larger supported antenna, can be directly applied, thus becoming the electrical non-lead contact. The RFID die chip is configured with the contact pad with the termination pad facing up, bonded to the support substrate, and with the bridging bonding conductor, and antenna in the same geometric plane. The bridging elastomeric conductive coating, to and over the edge of the die chip terminal contacts, bonds to the antenna overcoming the peril of this mismatch coefficient of linear expansion. The process for fabricating the RFID device of the instant invention, (Single Plane Direct "Bridging" Interconnect Bonding - SPDBIB) does not require any stressful, direct thermal exposure to the die chip or the require related bonding pressure degradation of the current process. This RFID device is relatively a flat configuration because there are no chip bonding bumps. There are no contact face void areas because of the face up design. Useful features of the instant invention include the approach to the bonding material composition, method of fabrication and the RFID device design of the system with an conductive coating antenna existing in a single plane.

BRIEF DESCRIPTION OF THE DRAWINGS

Various embodiments are described below with reference to the drawings wherein:

Fig. 1 illustrates prior art wire bonding die chip interconnect;
Fig. 2 illustrates prior art flip chip lead solder die chip interconnect;
Fig. 3 illustrates prior art flip chip bonding;
Fig. 4 illustrates prior art anisotropic conductive film flip chip technology;
Fig. 5 illustrates a prior art ultrasonic process;
Fig. 6 is a perspective view of a computer chip mounted to a carrier substrate;
Fig. 7 is a side elevational view of a portion of the chip and substrate illustrating the conductive coating of the invention applied to the computer chip and carrier substrate;
Fig. 8 is a plan view illustrating an RFID device with printed conductive antenna;
Fig. 9 is a sectional elevational view illustrating an alternative embodiment of the RFID device employing a via connection between upper and lower patterned conductive coatings;
Fig. 10 ilustrates a process for single plane direct bridging interconnect bonding (SPDBIB); and,
Fig. 11 illustrates an alternative process for single plane direct bridging interconnect bonding (SPDBIB).

DETAILED DESCRIPTION OF PREFERRED EMBODIMENT(S)

The RFID device of the invention is a transponder, or tag, which includes a computer chip containing an integrated circuit with semiconductor memory capability in which digital information may be stored. The computer chip can include, for example, electrically erasable programmable read-only memory (EEPROM) or similar electronic memory device. The computer chip is mounted to a carrier substrate and can be a passive device, relying upon power from an electromagnetic field provided by a reader device, or it can be connected to its own power supply, such as a battery. The carrier substrate can be rigid or flexible, and includes an antenna mounted thereto, the antenna being fabricated from photo-etched circuits of metals such as copper or aluminum or a deposited electrically conductive elastomeric composition. The RFID device of the invention is designed with the face side of the die chip up and the interconnect consisting of special elastomeric polymer conductive composition, "bridging" terminating the dies pads to the antenna. The one sided characteristic of the RFID device of the invention allows a simpler way of fabricating it. This new process does not require direct heat and pressure or the need for underfilling.

The terms "insulating", "conducting", "resistance", "capacitance" and their related forms as used herein refer to the electrical properties of the materials described unless otherwise indicated.

Resistance refers to the opposition of the material to the flow of electric current along the current path in the material and is measured in ohms. Resistance increases proportionately with the length of the current path and the specific resistance, or resistivity of the material, and it varies inversely to the cross sectional area available to the current. The resistivity is a property of the material and may be thought of as a measure of (resistance/length)/area. The resistance is determined in accordance with the following formula (I):

$$R = \rho L/A \qquad\qquad\qquad\qquad (I)$$

where
R = resistance in ohms

$\rho$ = resistivity in ohm-inches (1 ohm-inch $\cong$ 2,54 ohm.cm)

L = length in inches (1 inch $\cong$ 2,54 cm)

A = area in square inches. (1 inch$^2$ $\cong$ 6,4516 cm$^2$)

The current through a circuit varies in proportion to the applied voltage and inversely with the resistance, as provided by Ohm's Law:

$$I = V/R \qquad\qquad\qquad (II)$$

where

I = current in amperes

V = voltage in volts

R = resistance in ohms.

Typically, the resistance of a flat conductive sheet across the plane of the sheet, i.e., from one edge to the opposite edge, is measured in units of ohms per square. For any given thickness of the conductive sheet, the resistance value across the square remains the same no matter what the size of the square is. In applications where the current path is from one surface to another, i.e., in a direction perpendicular to the plane of the sheet, resistance is measured in ohms.

The term capacitance of the amount of electric charge stored (or separated) for given electric potential. The capacitance is usually defined as the total electric charge placed on the object divided by the potential of the object, where:

C is the capacitance in farads, F

Q is the charge in coulombs, C

V is the potential in volts, V

F is the electric flux associated with the charge Q in coulombs

Therefore:

$$C = Q/V$$

or according to Gauss's law the capacitance can be expressed as the electric flux/volt

$$C = F/V$$

The terms elastomer and elastomeric as used herein refer to a material that can undergo at least 2% deformation elastically, preferably at least 5% deformation and more preferably at least 10% deformation elastically, i.e. without taking a set and without significant change in the conductive properties of the conductive coating. Elastomeric materials suitable for the purposes described herein include polymeric materials such as, plasticized polyvinyl chloride (PVC), PET (Polyethylene Terephthalate), thermoplastic or thermoset polyurethane, silicone, and natural and synthetic rubbers.

An optional feature of the present invention is the use of green rubber. The term green rubber refers to a thermoset elastomeric polymer rubber stock or compound, in some form, which has not been completely vulcanized or cured. The green strength of the rubber stock is the resistance to deformation of the rubber stock in the uncured, or only partially cured, green state. In the green state the polymer can be injection molded, extruded, and otherwise formed into various shapes. The green rubber can be provided in the form of sheets which can be processed at room temperature by calendering, rolling, pinching, laminating, and embossing, etc., and can be coated and shaped into various configurations. The green rubber can be vulcanized by heating it to a temperature at which the molecular structure undergoes cross-linking. Vulcanization increases the elasticity of the rubber stock but renders the rubber less plastic. Typically, green rubber can be cured at from about 137,8°C (280°F) to about 204,4°C (400°F) for about 10 minutes to 60 minutes. A green compounded rubber suitable for use in the present invention is based on ethylenepropylene-diene monomer (i.e., EPDM) formulations, and is commercially available in sheet form from various suppliers such as Salem Republic. Rubber Company of Sebring, Ohio. Salem Republic Rubber Company's sheet compound, SRR EPDM #365-0, is preferable because of its high Mooney Viscosity. Cold or warm formed configurations made from sheet prepared with lower viscosity compounds lose their shape during vulcanizing. Because of the tackiness of rubber in the green state, a release sheet having a non-stick surface such as coated release paper, polyethylene film, or other such non-stick sheet, is generally co-wound with the green rubber, serving as a release interface, to prevent the rubber from sticking to itself.

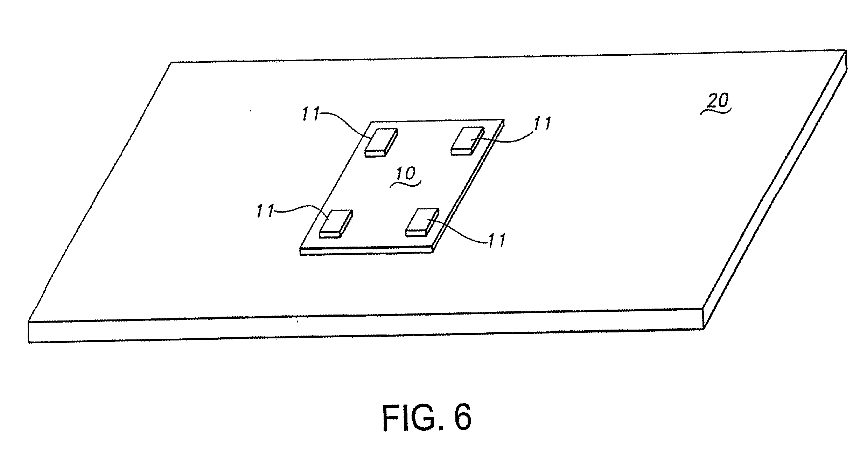

Referring now to Fig. 6, a dielectric carrier substrate 20 is fabricated from a sheet of any type of suitable insulating material such as paper, polymeric film (e.g., polyolefin, polyurethane, polyester (MYLAR), Polyethylene terephthalate (PET), etc.), ceramic, glass, and the like. The carrier substrate 20 can be rigid, but is preferably flexible or supple. In an embodiment of the invention the carrier substrate is fabricated from a supple material such as PET.

A chip 10 includes an integrated circuit (not shown) preferably with semiconductor memory in which digital information can be stored. Contact pads 11 on the chip 10 are conductive terminals for providing electrical.contact between the integrated circuit of the chip 10 and the patterned metal or conductive polymeric coating 30a. Contact pads 11 can be, for example, metal films such as copper, aluminum, silver, gold, and the like. The contact pads 11 can be bumped or unbumped (i.e., bare) and placed up.

The chip 10 is affixed to the carrier substrate 20 by adhesive bonding or any other suitable method.

The chip 10 can typically have a length of 0.2 to 1.0 mm (200 to 1,000 microns), a width of 0.2 to 0.5 mm (200 to 500 microns), preferably a length of 0.55 to 0.65 mm (550 to 650 microns), and a width of 0.35 to 0.45 mm (350 to 450 microns). The conductive terminals can have a length and/or width of 0.04 to 0.1 mm (40 to 100 microns), preferably 0.06 to 0.07 mm 60 to 70 microns. These ranges are given for illustrative purposes only and do not constitute limitations on the scope of the invention. Dimensions outside of these ranges can be used whenever appropriate.

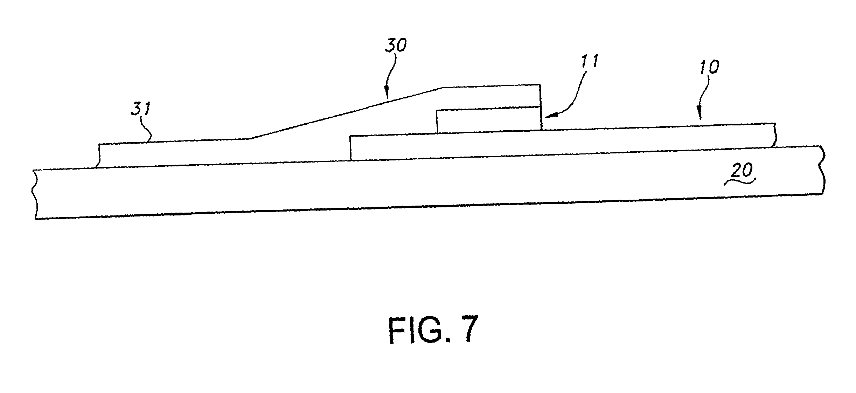

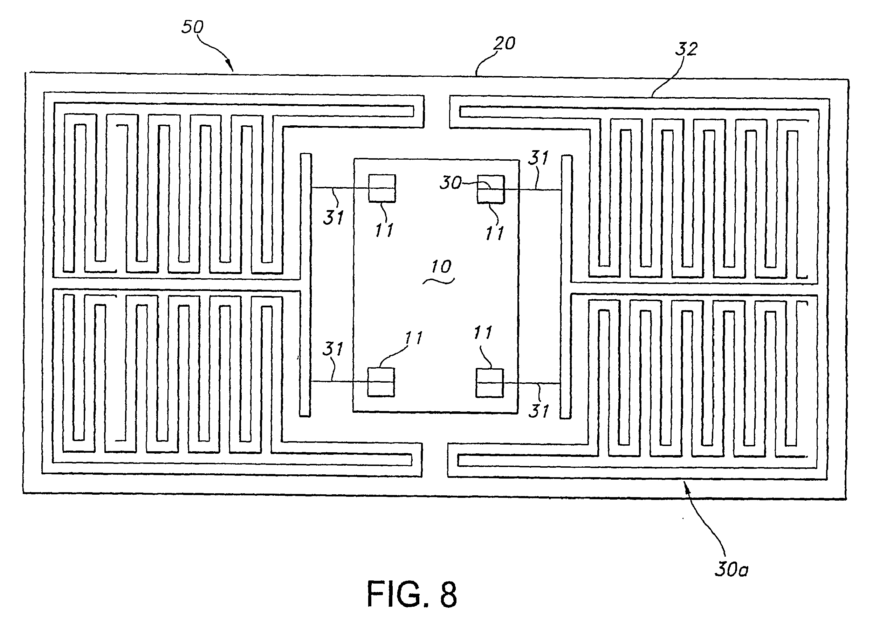

Referring now to Figs. 7 and 8, a portion of the carrier substrate and chip 10 is shown illustrating a line of conductive bridging (single plane direct bridging interconnect bonding - SPDBIB) coating 30 applied to the carrier substrate 20, the chip 10 and conductive terminal 11. The bridging coating 30 may be applied as a fluid by any suitable method such as casting, roller, spraying, silk screening, rotogravure printing, knife coating, curtain coating, offset printing, jetting, rotary screen printing, inkjet, lithography, and the like, followed by drying or curing the conductive coating.

The bridging coating 30 possesses excellent adhesion to the surfaces to which it is applied. The dried/cured SPDBIB bridging coating 30 is sufficiently elastomeric to accommodate different coefficients of thermal expansion between the chip 10 and the carrier substrate 20. Breaks in the bridging coating 30 caused by change in the environmental temperature are thereby avoided. The coating 30 typically ranges in thickness from about 0.00254 to 0.0762 mm (0.0001 inches to 0.03 inches (0.1 mil to about 30 mils)). In a preferred embodiment of the invention the bridging coating 30 as dried composite, or cured thermoset composite is similar to patterned conductive coating 30a except the metal filler level and viscosity are higher. The higher viscosity accommodates the Asymtech DJ 9000 jet coating dispensing machine. This jet application produces a thicker conforming coating cross-section. The higher viscosity is also suitable for silk screening applications. The bridging coating 30 formula can be modified with carbon/graphite fillers substituted for metal powders to function as a low resistance conductor (0.001 to about 10 ohms per square) or as a resistive element in a circuit (300 ohms to 100 kilo-ohms per square.) The resistive film can be use as a film resistor for broader applications The ranges given above are for illustrative purposes. Values outside of these ranges can be used when appropriate.

The conductive coatings consist of a conductive filler dispersed into an elastomer resin solution and applied to a flexible or supple matrix material , such as PET, Mylar, paper and the likes, and thereafter dried. The combination of conductive finely divided particles with or without conductive fibers allows the conductive filler to be premixed into the resin. The conductive filler can comprise an effective amount of conductive powder with or without an effective amount of conductive fiber. The particle size of the conductive powder (including nanopowders) typically ranges from diameters of about (nanopowders) 20 to 210 nm and pigment powder 0.00001 to about 0.025 mm (0.01 to about 25 microns) the particles being irregularly shaped, but having a generally flake or round configuration. The conductive fibers can be metal fibers or, preferably, graphite, and typically range from about 0.254 to about 12.7 mm (0.01 to about 0.5 inches) in length. Typically, the amount of conductive powder ranges from about 15% to about 80% by weight of the total composition. The conductive fibers typically range from about 0.1% to about 10% by weight of the total composition. The conductive filler is a particulate comprising a material selected from the group consisting of silver, copper, gold, zinc, aluminum, nickel, stainless steel, tin, silver coated copper, silver coated glass, silver coated aluminum, silver coated plastic, graphite powder, graphite fibers, nanofibers of silver or any of the metals stated above, nanopowder of silver or any of the metals stated above carbon fibers and carbon nanofibers, silver nanofibers, silver coated nanofiber, or nanotubes coated with any of the metals stated above. Nanofiber outer diameter from 1.1 to 200 nm and length 0.1 to 500 um.

Using a silver particulate filler the composition can possess a resistance of as low as 0.001 ohms per square. Using nanofibers of graphite, carbon, silver, gold or any of the other metals listed above, a resistance value of 0.0001 to 0.01 ohms per square can be achieved.

Polymeric resins used for the matrix material of the coating 30 can include elastomeric PVC or other vinyl polymers, polyurethane thermoset resins, polyurethane thermoplastic resins, silicones, and EPDM rubber resin systems.

Solvents useful in the preparation of the coating formulations of the invention include, but are not limited to, tetrahydrofuran (THF), methylethyl ketone (MEK), diethyl ketone, acetone, butyl acetate, isopropanol, naphtha, toluene, xylene, water or non-hazardous air pollutant (non-HAP) fluids.

The coating material formulations are made by physically combining the matrix resin, conductive filler particles, solvent, and optionally other additives such as plasticizers, thickeners for viscosity control, adhesion promoters such as silanes, antioxidants, oxidants, de-foaming agents or other functional additives. Examples of suitable materials include: plasticizers - Dioctylphthallate (DOP); thickeners - amorphous fumed silica (Cab-O-Sil) or crystalline silica (Bentonite); adhesion promoters - vinyl trethoxysilane; antioxidants - Salicylaldehye; oxidants - Dicumylperoxide; and defoaming agents - silicone variety.

The following Tables illustrate various preferred formulations. Table 1 illustrates a basic formulation.

TABLE 1

| Basic Formulation | |
|---|---|
| COMPONENT | AMOUNT (parts by weight) |
| Polyurethane resin (28.9% solids in THF) | 1.7 - 7 parts |
| Silver pigment | 4.5 - 15 parts |
| MEK or non-HAP solvent | 20 - 70 parts |

Table 2 illustrates a conductive paint formulation especially suitable for application by a spray gun to spray coat a conductive film onto a substrate. This formulation can reach a value of 0.01 ohms/square for a coating thickness of 0.00254 mm (0.0001 inches) to about 0.0762 mm (0.003 inches). After application the formulation can be flash dried or externally dried in an oven at 70C° for 20 minutes. Room temperature drying for a longer period is also possible.

TABLE 2

| (Conductive Paint Formulation) | |
|---|---|
| COMPONENT | AMOUNT (parts by weight) |
| Resin (Thermoset Polyurethane) | 10 - 30 parts |
| Reducing Agent (Salicylaldehyde) | 1.0 - 0.1 parts |
| Silane (Hydrosil) | 1.5 - 0.1 parts |
| Potter silver coated copper flake | 40 - 120 parts |
| MEK or special non-HAPS solvent | 50 parts |

Table 3 illustrates a green rubber formulation. When applied to a green rubber substrate, dried and cured at a curing temperature (e.g., 137.8°C - 204.4°C (280°F - 350°F)) the coating and the substrate become connected by molecular crosslinking so as to form an integral seamless single structure.

TABLE 3

| Green Rubber Formulation | |
|---|---|
| COMPONENT | AMOUNT (parts by weight) |
| Resin (Green Rubber - Formulated EPDM Compound) | 1.7 - 7 parts |
| Silver Flake Powder | 4.5 - 15 parts |
| Toluene or Hexane | 20 - 70 parts |

Table 4 illustrates a green rubber formulation employing graphite and carbon fillers.

TABLE 4

| (Green Rubber Graphite Example Formula) | |
|---|---|
| COMPONENT | AMOUNT (parts by weight) |
| Green Rubber Resin- (Green Rubber - Formulated EPDM Compound) | 5 - 20 parts |
| Graphite Fiber (1/64 to 2 inches long) | 1.0 - 0.05 parts |

(continued)

| (Green Rubber Graphite Example Formula) | |
|---|---|
| COMPONENT | AMOUNT (parts by weight) |
| Carbon Powder | 0.1 - 0.0005 parts |
| Graphite Powder (or metal) | 2.5 - 9 parts |
| Toluene or Hexane | 20 - 70 parts |

Table 5 illustrates a conductive coating formulation employing a silicone rubber matrix.

TABLE 5

| COMPONENT | AMOUNT (parts by weight) |
|---|---|
| Resin (Silicone Rubber) | 1.7 - 7 parts |
| Silver Flake Powder | 4.5 - 15 parts |
| MEK or non-HAP solvent | 10 - 70 parts |

Table 6 illustrates a coating useful as a resistor in an electrical circuit. The resistance can be controlled by using more or less graphite or carbon filler. Resistance for this coating typically ranges from about 0.001 ohms/square to 5 ohms/square for a thickness of 0.00254 mm (0.0001 inches) to about 0.0762 mm (0.003 inches).

TABLE 6

(Resistor Formulation)

| COMPONENT | AMOUNT (parts by weight) |
|---|---|
| Silicone Rubber Resin | 5.0 - 20 parts |
| Graphite Fiber (1/64 to 2 inches long) | 1.0 - 0.05 parts |
| Carbon Powder | 0.1 - 0.0005 parts |
| Graphite Powder (or metal) | 2.5 - 95 parts |
| MEK or non-HAP solvent | 10 - 70 parts |

An alternative formulation can be made by combining 60 parts graphite pigment (Asbury graphite A60), 0.4 parts carbon black (Shawingigan Black A) to form the filler, and dispersing the filler into 100 parts of plasticized PVC resin with enough solvent to provide the desired viscosity. The composition can be applied by spraying to form a film on the substrate having a sheet resistance of from about 100 to 1,000 ohms/square. Silver flake can be combined with the filler to provide lower sheet resistance.

Table 7 illustrates a elastomeric thermoset resin system based formulation which is suitable for application to the carrier substrate by silk screening. Alternatively, MEK or non-HAP solvent can be added to reduce the viscosity for spraying, etc.

TABLE 7

| COMPONENT | AMOUNT (parts by weight) |
|---|---|
| Aromatic Urethane Acrylic Resin | 6 - 18 parts |
| Trimethyolprane trimethaacrylate | 1 - 3 parts |
| Polyester acetate | 2 - 6 parts |
| Acrylated Polyester Oligomer | 1 - 3 parts |
| Cyclohexane Diacrylate | 2 - 6 parts |
| Peroxide (Benzoyl peroxide or Dicumyl peroxide) | 0.7 - 0.02 parts |
| Cobalt naphthanate (solids) | 0.01 - 0.3 parts |
| Silver Flake Particulate | 50 - 90 parts |

Table 8 illustrates a basic conductive coating formulation employing nanofibers.

TABLE 8

| COMPONENT | AMOUNT (parts by weight) |
|---|---|
| Polyurethane (28.9% Solids with THF) | 1.7 - 80 parts |
| Nanofibers - graphite, carbon, silver*, gold, nickel, stainless steel, tin, copper | 1- 50 parts |
| MEK or special non-HAP solvent | 20 - 70 parts |
| * Silver coated graphite or carbon nanofibers or nanofiber tubes | |

Table 9 illustrates a conductive coating formulation employing nanofibers in a thermoplastic polyurethane resin, with additives, which is suitable for silk screen application.

TABLE 9

| COMPONENT | AMOUNT (parts by weight) |
|---|---|
| Resin (Thermoset plastic Polyurethane) | 10 - 30 parts |
| Reducing Agent (Salicylaldehyde) | 1.0 - 0.1 parts |
| Silane (Hydrosil) | 1.5 - 0.1 parts |
| Nanofibers - graphite, carbon, silver*, gold, nickel, stainless steel, tin, copper | 1 - 60 parts |
| MEK or special non-HAPS solvent | 50 parts |
| * Silver coated graphite or carbon nanofibers or nanofiber tubes | |

Table 10 illustrates a coating formulation based upon green rubber matrix and nanofibers.

TABLE 10

| COMPONENT | AMOUNT (parts by weight) |
|---|---|
| Resin (Green Rubber - EPDM) | 1.7 - 7 parts |
| Nanofibers - graphite, carbon, silver*, gold, nickel, stainless steel, tin, copper | 1 - 50 parts |
| Toluene or Hexane | 20 - 70 parts |
| * Silver coated graphite or carbon nanofibers or nanofiber tubes | |

Table 11 illustrates a formulation including silicone rubber and nanofibers.

TABLE 11

| COMPONENT | AMOUNT (parts by weight) |
|---|---|
| Silicone Rubber | 1.7 - 7 parts |
| Nanofibers - graphite, carbon, silver* gold, nickel, stainless steel, tin, copper | 1-50 parts |
| Toluene | 20-70 parts |
| * Silver coated graphite or carbon nanofibers or nanofiber tubes | |

Conductive coatings employing nanofibers can also include plasticized PVC.
Table 12 illustrates a formulation employing an elastomeric thermoset polyurethane resin which is suitable for silk screen application to a substrate.

TABLE 12

| COMPONENT | AMOUNT (parts by weight) |
|---|---|
| Aromatic Urethane Acrylic Resin | 6 - 18 parts |

(continued)

| COMPONENT | AMOUNT (parts by weight) |
|---|---|
| Trimethyolprane trimethacrylate | 1 - 3 parts |
| Polyester acetate | 2 - 6 parts |
| Acrylated Polyester Oligomer | 1 - 3 parts |
| Cyclohexane Diacrylate | 2 - 6 parts |
| Peroxide (Benzoyl peroxide or Dicumyl peroxide) | 0.7 - 0.02 parts |
| Cobalt naphthanate (solids) | 0.01 - 0.3 parts |
| Nanofibers - graphite, carbon, silver*, gold, nickel, stainless steel, tin, copper | 1 - 50 parts |
| * Silver coated graphite or carbon nanofibers or nanotubes | |

All the above coatings can have nano particles substituted for the metal nanofibers, or metal coated nanofibers or nanotubes. Also, mixtures of standard metal particle fillers and fibers, nanofibers, or metal coated nanofibers or nanotubes, with nano particles is within the scope of this instant invention.

The coating formulations can be pastes, liquids or inks which are applied to the substrate and then dried (e.g., by evaporation of solvent) or cured (by elevated temperatures, UV, radiation or other curing method) to form an integral coating.

Referring again now to Fig. 8, patterned conductive coating 30a is applied over carrier substrate 20. Bridging coating 30 provides an electrical connection between the patterned conductive coating 30a and the terminals 11 of the integrated circuit chip 10. In a preferred embodiment of the invention patterned conductive coating 30a is similar to bridging coating 30, but its viscosity and pigment filler levels can be the same or different. As can be seen from Figs. 7 and 8, the patterned conductive coating 30a includes a connecting portion 31 electrically connected by the bridging coating 30 to the chip 10, and antenna portion 32 which is at the same planar level as the chip 10. In an alternative embodiment patterned conductive coating 30a can comprise a metal film.

The coatings 30a can be varied in composition and geometric configuration and position to provide desired values for conductance, impedance, resistance, capacitance, inductance, resonance, permittivity, permeability and dielectric value.

Alternative construction arrangements may alternatively be employed. For example, crossovers can be fabricated in which a portion of a first line of a conductive coating is overlaid with a non-conductive coating. A second line of conductive coating can then be applied to as to crossover the first line at the insulated portion. Moreover, layers of conductive coating separated by an insulative layer can perform the function of a capacitor in an electric circuit. Furthermore, conductive vias can be fabricated from single or multiple through-holes between layers which are filled with conductive coating material.

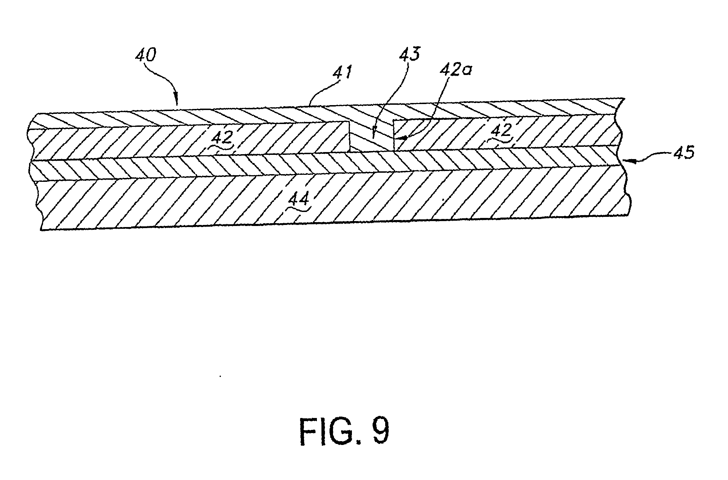

Referring now to Fig. 9, an embodiment 40 of the RFID device is shown wherein a first patterned conductive coating 45 is applied to one side of a perforated first nonconductive carrier substrate 42 (e.g., PET) containing openings 42a. A portion of the first patterned conductive coating 45 occupies openings 42a so as to provide conductive vias 43. An upper second patterned conductive coating 41 is applied to the other side of the second nonconductive substrate 42 such that a portion of the second patterned conductive coating contacts the vias so as to provide electrical connection to the lower first patterned conductive coating 45. A second nonconductive substrate 44 (e.g., paper) is applied to a side of the first carrier substrate 42 so as to form a non-conductive base layer. The conductive layers 41 and 45 can be fabricated so as to provide capacitor functionality to the electric circuit.

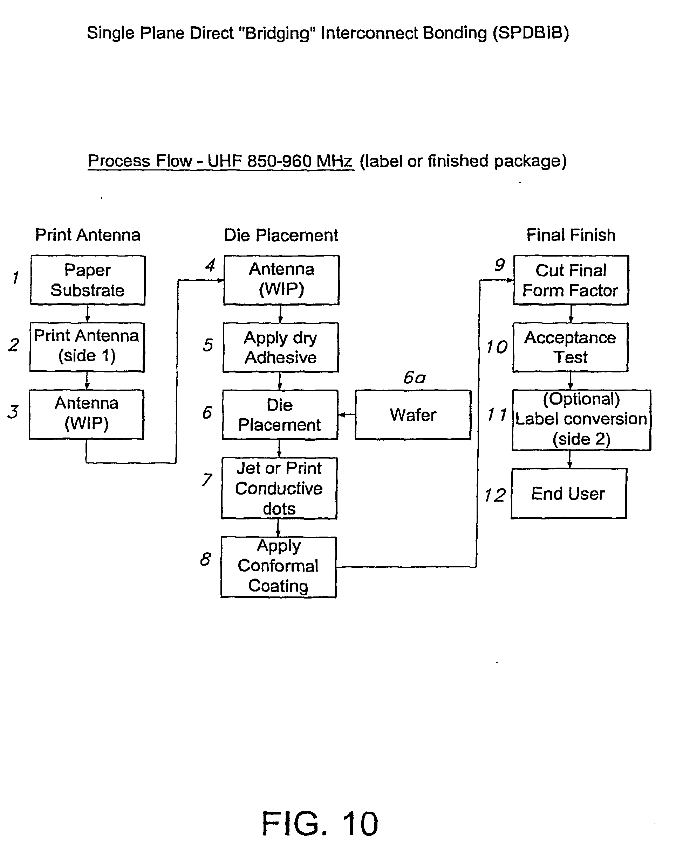

Referring to Fig. 10, a process flow diagram is shown for single plane direct bridging interconnect bonding (SPDBIB) for UHF 850-960 MHz (inlay or finished package). The process includes twelve steps leading to the end user of the RFID devices.

Step 1 is to unreel feed a paper or PET substrate into some form of printing, such as rotogravure. In an embodiment of the invention coating 30a is used to form the antenna. Continuous etching metal film pattern could be alternatively provided in this step.

Step 2 is the roto-printing operation.

Step 3 (Work in progress - WIP) is to rewind and transfer the material to Step 4, where the antenna sheet is feed to step 5.

Step 5 is the positioning feed of printed antenna substrate.

This step is followed by step 6 where the dry application of adhesive is applied to the back of the die chip and it is positioned and bonded to the antenna substrate. Step 6a is to provide the die chip (wafer) for step 6.

After this adhering operation, the process moves on to step 7: jet application of the SPDBIB coating 30 to form the interconnect between the die pads and the antenna.

A conformal protective coating is applied in step 8. The complete tag or inlay is coated with this conformal coating to protect the electrical components from moisture, while adding mechanical stability. Conformal coatings are known in the art and can be composed of thermoplastic or thermoset resins such as, for example, polyurethanes, epoxy resins, silicones, and the like.

Step 9 uses traditional slitting and perforating to provide a cut form of the work piece for downstream packaging.

Step 10 is the quality control operation in which the inlay or finished product is tested for electrical connectivity and transmission.

Optional step 11, offers labeling (applies blank paper on the non-antenna side) for future printing enabling human reading.

Step 12 represents the customers use of the device.

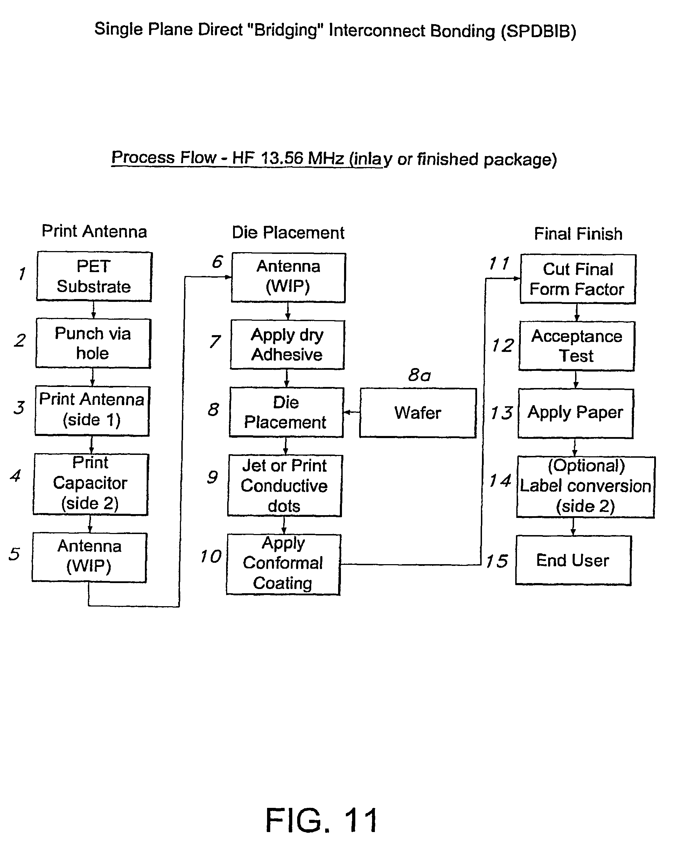

Referring to Fig. 11 an SPDBIB process flow diagram is shown for HF 13.56 MHz (inlay or finished package) which includes two sided use of the substrate. Similar to the process illustrated in Figure 10, fluid conductive coating formulation is used to form the antenna, also forming connections through the thru-holes or vias to patterned strip, printed under the antenna with coating 30a. When step 9 of Figure 11 is carried out not only are the die pads for the antenna connects provided, but also connections to the conductive thru-holes are made. Because the conductive thru-holes or vias are connected to said pattern bar, when the RFID is energized the metal coatings (antenna and conductive pattern bar) with the PET dielectric in between, cause a capacitance, which is used to power the device.

To describe the process of Fig. 11, fifteen steps are shown leading to the end user of the RFID devices.

Step 1 is to unreel feed a paper or the PET substrate into perforating operation of step 2.

The perforated PET is fed from step 2 to some form of printing, such as rotogravure, where both sides of PET substrate is printed.

Step 3 is the roto-printing operation, as discussed above may require two operations.

When the second coating (30a), step 4 is applied to print the pattern bar, the conductive coating flows through the vias to form the conductive thru-holes.

Step 5 (Work in progress - WIP) is to rewind and transfer the material to Step 6, where the antenna sheet is feed to Step 5.

Step 6 is the positioning feed of printed antenna substrate.

This step is followed by step 7 where the dry application of adhesive is applied to the back of the die chip and it is positioned in step 8 and bonded to the antenna substrate.

After this adhering operation, the process moves on to step 9 for Jet application of the SPDBIB coating 30 to form the interconnect between the die pads and the antenna.

A conformal protective coating is applied in step 10. The complete tag or inlay is coated with this conformal coating to protect the electrical components from moisture, while adding mechanical stability.

Step 11 uses traditional slitting and perforating to provide a cut form of the work piece for downstream packaging.

Step 12 is the quality control operation in which the inlay or finished product is tested for electrical connectivity and transmission.

Optional step 14 offers labeling (applies blank paper on the non-antenna side) for future printing enabling human reading. Step 12 represents the customer's use of the device.

**Claims**

1. A radio frequency identification device comprising:

   a) a non-conductive first substrate (20);
   b) an integrated circuit device (10) having a peripheral edge and being mounted to a top surface of the first substrate (20) and having at least one conductive terminal (11) on a top surface of said integrated circuit device (10);
   c) a patterned conductive coating (30a) applied to the top surface of the first substrate (20), said patterned conductive coating (30a) being formed into an antenna capable of receiving and conducting electromagnetic signals; and,
   d) a conductive bridging coating (30) electrically connecting the at least one terminal (11) of the integrated circuit to the patterned conductive coating (30a), the conductive bridging coating (30) including a polymeric matrix and a conductive particulate filler, said polymeric matrix being capable of undergoing at least 2% deformation elastically and without significant change in the conductive properties of the conductive bridging coating, wherein the conductive bridging coating (30) extends over the peripheral edge of the integrated circuit device (10).

2. The device of claim 1 comprising one of the following (i) - (vii);

> (i) wherein said polymeric matrix being capable of undergoing at least 10% deformation elastically and without significant change in the conductive properties of the conductive bridging coating; or
> (ii) wherein the first substrate (20) is flexible or supple; or
> (iii) wherein the first substrate (20) is fabricated from a material selected from the group consisting of paper, polymeric film, ceramic and glass; or;
> (iv) wherein the patterned conductive coating (30a) comprises a metal film, or;
> (v) wherein the patterned conductive coating comprises a polymeric matrix and a conductive particulate filler, said polymeric matrix being capable of undergoing at least 2% deformation elastically and without significant change in the conductive properties of the conductive bridging coating, or;
> (vi) further including a non-conductive second substrate with a second patterned conductive coating applied thereto, said second substrate including at least one via containing conductive coating material electrically joined to, and in physical contact with, both the second patterned coating on the second substrate and the patterned conductive coating on the non-conductive first substrate, or;
> (vii) wherein the conductive particulate filler includes nanofibers of graphite, carbon, silver, gold, nickel, stainless steel, tin or copper, or metallized nanotubes, metal coated graphite, or metal coated glass.

3. The device of claim 1 wherein the conductive terminal (11) of the integrated circuit device (10) and the surface of the first substrate (20) are on respective spaced-apart parallel planes.

4. The device of claim 2, part (iii) wherein the polymeric film comprises PET, mylar, and/or polyurethane.

5. The device of claim 2, part (v) wherein the patterned conductive coating is fabricated from cured green rubber.

6. The device of claim 5 wherein the first substrate is a cured green rubber and the patterned conductive coating and the first substrate are integrally formed as a single piece.

7. The device of claim 1, wherein the conductive bridging coating (30a) has a thickness ranging from 0.00254 mm (0.0001 inches) to 0.762 mm (0.03 inches) and a sheet resistance ranging from 0.001 to 10 ohms per square.

8. A method for making a radio frequency identification device of one of the preceding claims, comprising the steps of:

> a) providing a non-conductive carrier substrate (20);
> b) applying to a first surface of the substrate (20) a first patterned conductive coating (30a), said patterned conductive coating (30a) being formed into an antenna capable of receiving and conducting electromagnetic signals;
> c) affixing an integrated circuit chip (10) to the first surface of the carrier substrate (20);
> d) applying a fluid second conductive coating formulation to the substrate (20) and integrated circuit chip (10) to form a bridging electrical connection between the integrated circuit chip (10) and the patterned first conductive coating (30a), wherein said fluid conductive coating formulation includes a polymeric matrix material, a solvent, and a conductive particulate filler dispersed in said matrix, said polymeric matrix being capable of undergoing at least 2% deformation elastically and without significant change in the conductive properties of the second conductive coating when cured or dried; and,
> e) curing or drying the second conductive coating formulation.

9. The method of claim 8 comprising one of the following (i) -(xii)

> (i) wherein the polymeric matrix is capable of undergoing at least 10% deformation elastically and without significant change in the electrical properties of the second conductive coating, or;
> (ii) wherein the non-conductive carrier substrate (20) is fabricated from paper, polymeric film, ceramic, or glass, or;
> (iii) wherein the non-conductive carrier substrate (20) is fabricated from PET, mylar, and/or polyurethane; or
> (iv) wherein the step (c) of affixing is done by adhesive bonding; or
> (v) wherein the step (d) of applying the fluid second conductive coating is performed by a printing operation selected from casting, roller, spraying, silk screening, rotogravure printing, knife coating, curtain coating, offset printing, jetting, rotary screen, ink-jetting and lithography, or;
> (vi) wherein the polymeric matrix includes a material selected from the group consisting of plasticized polyvinyl chloride, polyurethane, silicone, and natural and synthetic rubbers, or;

(vii) wherein the fluid second conductive coating formulation includes additives selected from the group consisting of plasticizers, thickeners, reducing agents, adhesion promoters, antioxidants, oxidants and defoaming agents, or;

(viii) wherein the step (e) of curing comprises drying the fluid second conductive coating formulation by removing the solvent therefrom and/or by chemically crosslinking the polymeric matrix material, or;

(ix) wherein the patterned first conductive coating is applied as a fluid first conductive coating formulation which includes a polymeric matrix material, a solvent, and a conductive particulate filler dispersed in said matrix, said polymeric matrix material being capable of undergoing at least 2% deformation elastically and without significant change in the conductive properties of the second conductive coating when cured; or

(x) wherein the first patterned conductive coating comprises a metal film, or;

(xi) further including applying a second patterned conductive coating to an opposite second surface of the carrier substrate, said carrier substrate including at least one conductive via for electrically connecting the first and second patterned conductive coatings.

10. The method of claim 9, part (ix) comprising one of the following (a) - (c):

(a) wherein the nonconductive carrier substrate is fabricated from green rubber and the polymeric matrix material comprises green rubber, and step (e) further comprises thermally curing the carrier substrate and the polymeric matrix material together so as to form an integral single piece structure, or;

(b) applying a second patterned conductive coating to a second surface of the non-conductive carrier substrate opposite the first surface, wherein perforations are made in the non-conductive carrier substrate so as to provide vias for electrical connection between said first and second patterned conductive coatings, or;

(c) further comprising varying the composition, position and/or geometric configuration of the first patterned conductive coating to provide predetermined values of one or more of conductance, impedance, resistance, capacitance, inductance, resonance, permittivity, permeability and dielectric value.

11. The method of claim 10, part (b) wherein the first and second patterned conductive coatings are applied by a printing operation selected from casting, roller, spraying, silk screening, rotogravure printing, knife coating, curtain coating, offset printing, jetting, rotary screen, ink-jetting and lithography.

12. The method of claim 11 further comprising affixing a non-conductive base layer to the printed non-conductive carrier substrate.

13. The method of one of claims 8 to 12 wherein the fluid second conductive coating is applied to one or more bumped or unbumped terminals of the integrated circuit chip placed either up or down and connected to the antenna.

14. The method of claim 8, wherein the fluid second conductive coating is applied in a thickness ranging from 0.00254 mm (0.0001 inches) to 0.762 mm (0.03 inches) and a sheet resistance ranging from 0.001 to 10 ohms per square.

**Patentansprüche**

1. Funkfrequenzidentifizierungsvorrichtung, welche umfasst:

a) ein nicht leitendes erstes Substrat (20);

b) eine integrierte Schaltungsvorrichtung (10), die eine periphere Kante aufweist und an einer oberen Fläche des ersten Substrats (20) angebracht ist und mindestens einen leitenden Anschluss (11) auf einer oberen Fläche der integrierten Schaltungsvorrichtung (10) aufweist;

c) eine strukturierte leitende Beschichtung (30a), die auf der oberen Fläche des ersten Substrats (20) aufgebracht ist, wobei die strukturierte leitende Beschichtung (30a) zu einer Antenne ausgebildet ist, die elektromagnetische Signale empfangen und leiten kann; und

d) eine leitende Brückenbeschichtung (30), die den mindestens einen Anschluss (11) der integrierten Schaltung mit der strukturierten leitenden Beschichtung (30a) elektrisch verbindet, wobei die leitende Brückenbeschichtung (30) eine Polymermatrix und einen leitenden Partikelfüllstoff umfasst, wobei die Polymermatrix mindestens 2% Verformung elastisch und ohne signifikante Änderung der leitenden Eigenschaften der leitenden Brückenbeschichtung unterzogen werden kann kann, wobei sich die leitende Brückenbeschichtung (30) über die periphere Kante der integrierten Schaltungsvorrichtung (10) erstreckt.

**2.** Vorrichtung nach Anspruch 1, welche eines der folgenden (i) - (vii) umfasst:

(i) wobei die Polymermatrix mindestens 10% Verformung elastisch und ohne signifikante Änderung der leitenden Eigenschaften der leitenden Brückenbeschichtung unterzogen werden kann; oder

(ii) wobei das erste Substrat (20) biegsam oder nachgiebig ist; oder

(iii) wobei das erste Substrat (20) aus einem Material gewählt aus der Gruppe bestehend aus Papier, Polymerfilm, Keramik und Glas hergestellt ist; oder

(iv) wobei die strukturierte leitende Beschichtung (30a) eine Metallschicht umfasst; oder

(v) wobei die strukturierte leitende Beschichtung eine Polymermatrix und einen leitenden Partikelfüllstoff umfasst, wobei die Polymermatrix mindestens 2% Verformung elastisch und ohne signifikante Änderung der leitenden Eigenschaften der leitenden Brückenbeschichtung unterzogen werden kann; oder

(vi) welche weiterhin ein nicht leitendes zweites Substrat mit einer darauf aufgebrachten zweiten strukturierten leitenden Beschichtung umfasst, wobei das zweite Substrat mindestens eine Durchkontaktierung umfasst, die leitendes Beschichtungsmaterial enthält, das mit sowohl der zweiten strukturierten Beschichtung auf dem zweiten Substrat als auch mit der strukturierten leitenden Beschichtung auf dem nicht leitenden ersten Substrat elektrisch verbunden ist und in physikalischem Kontakt damit steht; oder

(vii) wobei der leitende Partikelfüllstoff Nanofasern aus Graphit, Kohlenstoff, Silber, Gold, Nickel, Edelstahl, Zinn oder Kupfer oder metallisierte Nanoröhren, metallbeschichtetes Graphit oder metallbeschichtetes Glas umfasst.

**3.** Vorrichtung nach Anspruch 1, wobei sich der leitende Anschluss (11) der integrierten Schaltungsvorrichtung (10) und die Oberfläche des ersten Substrats (20) auf jeweiligen beabstandeten parallelen Ebenen befinden.

**4.** Vorrichtung nach Anspruch 2, Teil (iii), wobei der Polymerfilm PET, Mylar und/oder Polyurethan umfasst.

**5.** Vorrichtung nach Anspruch 2, Teil (v), wobei die strukturierte leitende Beschichtung aus vulkanisiertem grünen Kautschuk hergestellt ist.

**6.** Vorrichtung nach Anspruch 5, wobei das erste Substrat ein vulkanisierter grüner Kautschuk ist und die strukturierte leitende Beschichtung sowie das erste Substrat integral einteilig ausgebildet sind.

**7.** Vorrichtung nach Anspruch 1, wobei die leitende Brückenbeschichtung (30a) eine Dicke, die von 0,00254 mm (0,0001 Zoll) bis 0,762 mm (0,03 Zoll) reicht, und einen Schichtwiderstand, der von 0,001 bis 10 Ohm pro Quadrat reicht, aufweist.

**8.** Verfahren zum Herstellen einer Funkfrequenzidentifizierungsvorrichtung nach einem der vorhergehenden Ansprüche, welches folgende Schritte umfasst:

a) Vorsehen eines nicht leitenden Trägersubstrats (20);

b) Aufbringen einer ersten strukturierten leitenden Beschichtung (30a) auf eine erste Oberfläche des Substrats (20), wobei die strukturierte leitende Beschichtung (30a) zu einer Antenne ausgebildet ist, die elektromagnetische Signale empfangen und leiten kann;

c) Befestigen eines integrierten Leitungschips (10) an der ersten Oberfläche des Trägersubstrats (20);

d) Aufbringen einer fluiden zweiten leitenden Beschichtungsformulierung auf das Substrat (20) und den integrierten Leitungschip (10), um zwischen dem integrierten Leitungschip (10) und der strukturierten ersten leitenden Beschichtung (30a) eine überbrückende elektrische Verbindung zu bilden, wobei die fluide leitende Beschichtungsformulierung ein Polymermatrixmaterial, ein Lösungsmittel und einen leitenden Partikelfüllstoff, der in der Matrix dispergiert ist, umfasst, wobei die Polymermatrix mindestens 2% Verformung elastisch und ohne signifikante Änderung der leitenden Eigenschaften der zweiten leitenden Beschichtung unterzogen werden kann, wenn sie gehärtet oder getrocknet ist; und

e) Härten oder Trocknen der zweiten leitenden Beschichtungsformulierung.

**9.** Verfahren nach Anspruch 8, welches eines der folgenden (i) - (xii) umfasst:

(i) wobei die Polymermatrix mindestens 10% Verformung elastisch und ohne signifikante Änderung der elektrischen Eigenschaften der zweiten leitenden Beschichtung unterzogen werden kann; oder

(ii) wobei das nicht leitende Trägersubstrat (20) aus Papier, Polymerfilm, Keramik oder Glas hergestellt ist; oder

(iii) wobei das nicht leitende Trägersubstrat (20) aus PET, Mylar und/oder Polyurethan hergestellt ist; oder

(iv) wobei der Schritt (c) des Befestigens durch Kleben erfolgt; oder

(v) wobei der Schritt (d) des Aufbringens der fluiden zweiten leitenden Beschichtung durch einen Druckvorgang ausgewählt aus Gießen, Walze, Sprühen, Siebdruck, Rotationstiefdruck, Rakel-Beschichten, Vorhangbeschichten, Offsetdruck, Strahldrucken, Rotationsdruck, Tintenstrahldrucken und Lithographie ausgeführt wird; oder

(vi) wobei die Polymermatrix ein Material gewählt aus der Gruppe bestehend aus plastifiziertem Polyvinylchlorid, Polyurethan, Silicon und Natur- und Synthesekautschuk umfasst; oder

(vii) wobei die fluide zweite leitende Beschichtungsformulierung Zusätze gewählt aus der Gruppe bestehend aus Plastifizierungsmitteln, Verdickungsmitteln, Reduktionsmitteln, Adhäsionsbeschleunigern, Antioxidantien, Oxidantien und Schaumdämpfungsmitteln umfasst; oder

(viii) wobei der Schritt (e) des Härtens das Trocknen der fluiden zweiten leitenden Beschichtungsformulierung durch Entfernen des Lösungsmittels daraus und/oder durch chemisches Vernetzen des Polymermatrixmaterials umfasst; oder

(ix) wobei die strukturierte erste leitende Beschichtung als fluide erste leitende Beschichtungsformulierung aufgebracht wird, die ein Polymermatrixmaterial, ein Lösungsmittel und einen leitenden Partikelfüllstoff, der in der Matrix dispergiert ist, umfasst, wobei das Polymermatrixmaterial mindestens 2% Verformung elastisch und ohne signifikante Änderung der leitenden Eigenschaften der zweiten leitenden Beschichtung unterzogen werden kann, es gehärtet ist; oder

(x) wobei die erste strukturierte leitende Beschichtung eine Metallschicht umfasst; oder

(xi) welches weiterhin das Aufbringen einer zweiten strukturierten leitenden Beschichtung an einer gegenüberliegenden zweiten Oberfläche des Trägersubstrats umfasst, wobei das Trägersubstrat mindestens eine leitende Durchkontaktierung für das elektrische Verbinden der ersten und zweiten strukturierten leitenden Beschichtung umfasst.

10. Verfahren nach Anspruch 9, Teil (ix), welches eines der folgenden (a) - (c) umfasst:

(a) wobei das nicht leitende Trägersubstrat aus grünem Kautschuk hergestellt ist und das Polymermatrixmaterial grünen Kautschuk umfasst und Schritt (e) weiterhin das thermische Härten des Trägersubstrats und des Polymermatrixmaterials miteinander umfasst, um eine integrale einteilige Struktur zu bilden; oder

(b) Aufbringen einer zweiten strukturierten leitenden Beschichtung auf eine zweite Oberfläche des nicht leitenden Trägersubstrats gegenüber der ersten Oberfläche, wobei in dem nicht leitenden Trägersubstrat Perforationen ausgeführt sind, um Durchkontaktierungen für die elektrische Verbindung zwischen der ersten und der zweiten strukturierten leitenden Beschichtung vorzusehen; oder

(c) wobei es weiterhin das Verändern der Zusammensetzung, Position und/oder geometrischen Konfiguration der ersten strukturierten leitenden Beschichtung umfasst, um vorbestimmte Werte eines oder mehrerer von: Leitfähigkeit, Impedanz, Widerstand, Kapazität, Induktivität, Resonanz, Permittivität, Permeabilität und dielektrischem Wert vorzusehen.

11. Verfahren nach Anspruch 10, Teil (b), wobei die erste und die zweite strukturierte leitende Beschichtung durch einen Druckvorgang ausgewählt aus Gießen, Walze, Sprühen, Siebdruck, Rotationstiefdruck, Rakel-Beschichten, Vorhangbeschichten, Offsetdruck, Strahldrucken, Rotationsdruck, Tintenstrahldrucken und Lithographie aufgebracht werden.

12. Verfahren nach Anspruch 11, welches weiterhin das Befestigen einer nicht leitenden Basisschicht an dem bedruckten, nicht leitenden Trägersubstrat umfasst.

13. Verfahren nach einem der Ansprüche 8 bis 12, wobei die fluide zweite leitende Beschichtung an einem oder mehreren erhabenen oder nicht erhabenen Anschlüssen des integrierten Schaltungschips aufgebracht wird, der entweder nach oben oder unten weisend platziert und mit der Antenne verbunden ist.

14. Verfahren nach Anspruch 8, wobei die fluide zweite leitende Beschichtung in einer Dicke, die von 0,00254 mm (0,0001 Zoll) bis 0,762 mm (0,03 Zoll) reicht, und mit einem Schichtwiderstand, der von 0,001 bis 10 Ohm pro Quadrat reicht, aufgebracht wird.

**Revendications**

1. Dispositif d'identification radiofréquence comprenant:

a) un premier substrat non conducteur (20);

b) un dispositif de circuit intégré (10) comportant un bord périphérique et monté sur une surface supérieure du premier substrat (20) et comportant au moins une borne conductrice (11) sur une surface supérieure dudit dispositif de circuit intégré (10);

c) un revêtement conducteur modelé (30a) appliqué à la surface supérieure du premier substrat (20), ledit revêtement conducteur modelé (30a) étant formé dans une antenne capable de recevoir et conduire des signaux électromagnétiques; et

d) un revêtement de pontage conducteur (30) connectant électriquement la au moins une borne (11) du circuit intégré au revêtement conducteur (30a), le revêtement de pontage conducteur (30) incluant une matrice polymère et une charge particulaire conductrice, ladite matrice polymère étant capable de subir une déformation élastique d'au moins 2 % et sans changement significatif des propriétés conductrices du revêtement de pontage conducteur, où le revêtement de pontage conducteur (30) s'étend sur le bord périphérique du dispositif du circuit intégré (10).

2.  Dispositif selon la revendication 1, **caractérisé par** l'un des éléments (i) à (vii) suivants:

(i) ladite matrice polymère est capable de subir une déformation élastique d'au moins 10 % et sans changement significatif des propriétés conductrices du revêtement de pontage conducteur; ou

(ii) le premier substrat (20) est flexible ou souple; ou

(iii) le premier substrat (20) est fabriqué d'un matériau choisi dans le groupe consistant en le papier, un film polymère, une céramique et le verre; ou

(iv) le revêtement conducteur modelé (30a) comprend un premier film; ou

(v) le revêtement conducteur modelé comprend une matrice polymère et une charge particulaire conductrice, ladite matrice polymère étant capable de subir une déformation élastique d'au moins 2 % et sans changement significatif des propriétés conductrices du revêtement de pontage conducteur; ou

(vi) il inclut en outre un second substrat non conducteur auquel est appliqué un second revêtement conducteur modelé, ledit second substrat incluant au moins un trou d'interconnexion contenant un matériau de revêtement conducteur électriquement joint à, et en contact physique avec, à la fois le second revêtement modelé sur le second substrat et le revêtement conducteur modelé sur le premier substrat non conducteur; ou

(vii) la charge particulaire conductrice inclut des nanofibres de graphite, carbone, argent, or, nickel, acier inoxydable, étain ou cuivre, ou des nanotubes métallisés, du graphite revêtu de métal ou du verre revêtu de métal.

3.  Dispositif selon la revendication 1, dans lequel la borne conductrice (11) du dispositif de circuit intégré (10) et la surface du premier substrat (20) sont sur des plans parallèles espacés respectifs.

4.  Dispositif selon la revendication 2, partie (iii), dans lequel le film polymère comprend du PET, du mylar et/ou du poly (uréthane).

5.  Dispositif selon la revendication 2, partie (v), dans lequel le revêtement conducteur modelé est fabriqué à partir de caoutchouc vert vulcanisé.

6.  Dispositif selon la revendication 5, dans lequel le premier substrat est un caoutchouc vert vulcanisé et le revêtement conducteur modelé et le premier substrat sont solidairement formés d'un seul tenant.

7.  Dispositif selon la revendication 1, dans lequel le revêtement de pontage (30a) a une épaisseur variant de 0,00254 mm (0,0001 pouce) à 0,762 mm (0,03 pouce) et une résistance de feuille variant de 0,001 à 10 ohms par carré.

8.  Procédé de fabrication d'un dispositif d'identification radiofréquence de l'une des revendications précédentes, comprenant les étapes consistant à:

(a) fournir un substrat porteur non conducteur (20);

(b) appliquer à une première surface du substrat (20) un premier revêtement conducteur modelé (30a), ledit revêtement conducteur modelé (30a) étant formé dans une antenne capable de recevoir et conduire des signaux électromagnétiques;

(c) fixer une puce de circuit intégré (10) à la première surface du substrat porteur (20);

(d) appliquer une seconde formulation de revêtement conductrice fluide au substrat (20) et à la puce de circuit intégré (10) pour former une connexion électrique de pontage entre la puce de circuit intégré (10) et le premier revêtement conducteur modelé (30a), où ladite formulation de revêtement conductrice fluide inclut un matériau de matrice polymère, un solvant, et une charge particulaire conductrice dispersée dans ladite matrice, ladite matrice polymère étant capable de subir une déformation élastique d'au moins 2 % et sans changement significatif des propriétés conductrices du second revêtement conducteur une fois vulcanisé ou séché; et

(e) vulcaniser ou sécher la seconde formulation de revêtement conductrice.

**9.** Procédé selon la revendication 8, **caractérisé par** l'un des éléments (i) à (xi) suivants:

(i) la matrice polymère est capable de subir une déformation élastique d'au moins 10 % et sans changement significatif des propriétés électriques du second revêtement conducteur; ou

(ii) le substrat porteur non conducteur (20) est fabriqué à partir de papier, film polymère, céramique ou verre; ou

(iii) le substrat porteur non conducteur (20) est fabriqué à partir de PET, mylar et/ou poly(uréthane); ou

(iv) l'étape (c) de fixation est effectuée par collage par adhésif; ou

(v) l'étape (d) d'application du second revêtement conducteur fluide est effectuée par une opération d'impression choisie parmi une impression par coulage, au rouleau, par pulvérisation, sérigraphie, héliogravure, revêtement au couteau, revêtement au rideau, impression offset, éjection, tamis rotatif, jet d'encre et lithographie; ou

(vi) la matrice polymère inclut un matériau choisi dans le groupe consistant en le poly(chlorure de vinyle) plastifié, le poly(uréthane), la silicone, et les caoutchoucs naturels et synthétiques; ou

(vii) la seconde formulation de revêtement conductrice fluide inclut des additifs choisis dans le groupe consistant en les plastifiants, les épaississants, les agents réducteurs, les promoteurs d'adhérence, les antioxydants, les oxydants et les agents antimousse; ou

(viii) l'étape (e) de vulcanisation comprend le séchage de la seconde formulation de revêtement conductrice fluide par élimination du solvant de celle-ci et/ou par réticulation chimique du matériau de matrice polymère; ou

(ix) le premier revêtement conducteur modulé est appliqué sous forme de première formulation de revêtement conductrice fluide qui inclut un matériau de matrice polymère, un solvant et une charge particulaire conductrice dispersée dans ladite matrice, ledit matériau de matrice polymère étant capable de subir une déformation élastique d'au moins 2 % et sans changement significatif des propriétés conductrices du second revêtement conducteur une fois vulcanisé; ou

(x) le premier revêtement conducteur modelé comprend un film métal; ou

(xi) il inclut en outre l'application d'un second revêtement conducteur modelé à une seconde surface opposée du substrat porteur, ledit substrat porteur incluant au moins un trou d'interconnexion conducteur pour connecter électriquement les premier et second revêtements conducteurs modelés.

**10.** Procédé selon la revendication 9, partie (ix), **caractérisé par** l'un des éléments (a) à (c) suivants:

(a) le substrat porteur non conducteur est fabriqué à partir de caoutchouc vert et le matériau de matrice polymère comprend du caoutchouc vert, et l'étape (e) comprend en outre la vulcanisation thermique conjointe du substrat porteur et du matériau de matrice polymère de façon à former une structure solidaire d'un seul tenant; ou

(b) l'application d'un second revêtement conducteur modelé à une seconde surface du substrat porteur non conducteur opposé à la première surface, où des perforations sont pratiquées dans le substrat porteur non conducteur de façon à former des trous d'interconnexion pour connexion électrique entre lesdits premier et second revêtements conducteurs modelés; ou

(c) il comprend en outre le fait de faire varier la composition, la position et/ou la configuration géométrique du premier revêtement conducteur modelé pour fournir des valeurs prédéterminées d'un ou plusieurs éléments parmi conductance, impédance, résistance, capacité, inductance, résonance, permittivité, perméabilité et valeur diélectrique.

**11.** Procédé selon la revendication 10, partie (b) dans lequel les premier et second revêtements conducteurs modelés sont appliqués par une opération d'impression choisie parmi une impression par coulage, au rouleau, par pulvérisation, sérigraphie, héliogravure, revêtement au couteau, revêtement au rideau, impression offset, éjection, tamis rotatif, jet d'encre et lithographie.

**12.** Procédé selon la revendication 11, comprenant en outre la fixation d'une couche de base non conductrice sur le substrat porteur non conducteur imprimé.

**13.** Procédé selon l'une des revendications 8 à 12, dans lequel le second revêtement conducteur fluide est appliqué à une ou plusieurs bornes bosselées ou non bosselées de la puce de circuit intégré, placées soit en haut soit en bas et connectées à l'antenne.

**14.** Procédé selon la revendication 8, dans lequel le second revêtement conducteur fluide est appliqué dans une épaisseur allant de 0,00254 mm (0,0001 pouce) à 0,762 mm (0,03 pouce) et une résistance de feuille variant de 0,001 à 10 ohms par carré.

Wire Bonding Die Chip Interconnect

FIG. 1

(PRIOR ART)

Flip Chip Lead Solder Die Chip Interconnect

LSI          PbSn Bump

Metallization

# FIG. 2
*(PRIOR ART)*

Flip Chip Bonding

Substrate with
landing pads

Chip with bumps

Chip placed on
substrate

# FIG. 3
*(PRIOR ART)*

Schematic of Anisotropic Conductive Film Flip
Chip Technology

# FIG. 4
*(PRIOR ART)*

Ultrasonic Process

Chip with solder bumps

Fluxing

Substrate with landing pads

Placement

Self-aligment of chip and substrate

Reflow

Underfill

Force and ultrasonic power

Gold bumps or
gold stud pumps

Heat

# FIG. 5
*(PRIOR ART)*

FIG. 6

FIG. 7

EP 1 900 025 B1

FIG. 8

EP 1 900 025 B1

FIG. 9

EP 1 900 025 B1

Single Plane Direct "Bridging" Interconnect Bonding (SPDBIB)

Process Flow - UHF 850-960 MHz (label or finished package)

### Print Antenna

1 | Paper Substrate

2 | Print Antenna (side 1)

3 | Antenna (WIP)

### Die Placement

4 | Antenna (WIP)

5 | Apply dry Adhesive

6 | Die Placement

6a | Wafer

7 | Jet or Print Conductive dots

8 | Apply Conformal Coating

### Final Finish

9 | Cut Final Form Factor

10 | Acceptance Test

11 | (Optional) Label conversion (side 2)

12 | End User

# FIG. 10

28

Single Plane Direct "Bridging" Interconnect Bonding (SPDBIB)

Process Flow - HF 13.56 MHz (inlay or finished package)

Print Antenna | Die Placement | Final Finish

1 — PET Substrate
2 — Punch via hole
3 — Print Antenna (side 1)
4 — Print Capacitor (side 2)
5 — Antenna (WIP)

6 — Antenna (WIP)
7 — Apply dry Adhesive
8 — Die Placement
8a — Wafer
9 — Jet or Print Conductive dots
10 — Apply Conformal Coating

11 — Cut Final Form Factor
12 — Acceptance Test
13 — Apply Paper
14 — (Optional) Label conversion (side 2)
15 — End User

FIG. 11

## REFERENCES CITED IN THE DESCRIPTION

**Patent documents cited in the description**

- EP 1143378 A

- FR 2745120